**Europäisches Patentamt**

**European Patent Office**

**Office européen des brevets**

(19)

(11) Veröffentlichungsnummer: **0 179 099**
**B1**

## EUROPÄISCHE PATENTSCHRIFT

(12)

(45) Veröffentlichungstag der Patentschrift:
**20.07.88**

(21) Anmeldenummer: **85901970.5**

(22) Anmeldetag: **16.04.85** .

(86) Internationale Anmeldenummer:
**PCT/DE 85/00119**

(87) Internationale Veröffentlichungsnummer:
**WO 85/05223 (21.11.85 Gazette 85/25)**

(51) Int. Cl.⁴: **H 01 L  27/08,** H 01 L  29/06,
H 01 L  29/72

(54) **MONOLITHISCH INTEGRIERTE PLANARE HALBLEITERANORDNUNG UND VERFAHREN ZU DEREN HERSTELLUNG.**

(30) Priorität: **04.05.84  DE 3416404**

(43) Veröffentlichungstag der Anmeldung:
**30.04.86 Patentblatt 86/18**

(45) Bekanntmachung des Hinweises auf die Patenterteilung:
**20.07.88 Patentblatt 88/29**

(84) Benannte Vertragsstaaten:
**CH DE FR GB IT LI NL SE**

(56) Entgegenhaltungen:
**WO-A-83/02528**
**US-A-4 034 395**

**Neues aus der Technik, Nr. 1/2, April 1983,
Würzburg, (DE) "Verfahren zur Bildung einer
CMOST-Struktur", siehe Seite 1, Spalte 1,
Abbildung 2**

(73) Patentinhaber: **ROBERT BOSCH GMBH, Postfach
50, D-7000 Stuttgart 1 (DE)**

(72) Erfinder: **FLOHRS, Peter, Wallensteinstrasse 38,
D-7410 Reutlingen 11 (DE)**
Erfinder: **MICHEL, Hartmut, Herderstrasse 74,
D-7410 Reutlingen (DE)**

## Beschreibung

### Stand der Technik

Die Erfindung geht aus von einer Halbleiteranordnung nach der Gattung des Hautanspruchs. Aus der DE-A-32 27 536 = WO-A-83 02 528 ist eine als Darlington-Transistorschaltung ausgebildete Halbleiteranordnung bekannt, bei der die beiden Transistoren in einem gemeinsamen Substrat in Planartechnik monolithisch integriert sind. Das Substrat bildet dabei die Kollektorzonen der beiden Transistoren. Auf der Hauptoberfläche des Substrats befindet sich eine aus Siliziumdioxid bestehende Passivierungsschicht, die diese Hauptoberfläche mit Ausnahme von Kontaktfenstern überdeckt. Die Basis-Kollektor-Übergänge der beiden Transistoren sind durch eine Metallelektrode geschützt, die sich über der Passivierungsschicht befindet und als Deckelektrode bezeichnet werden kann. Diese Halbleiterschaltung besitzt außerdem einen integrierten Spannungsteiler, dessen Abgriff mit der Deckelektrode verbunden ist. Das von der Deckelektrode ausgehende elektrostatische Feld beeinflußt die Durchbruchsspannung an den darunter befindlichen pn-Übergängen. Durch geeignete Wahl des Spannungsteilers kann eine Einstellung der Durchbruchsspannung vorgenommen werden, die jedoch bei der bekannten Halbleiteranordnung stark temperaturabhängig ist.

### Vorteile der Erfindung

Die erfindungsgemäße Halbleiteranordnung mit den Merkmalen des Hauptanspruchs hat demgegenüber den Vorteil, daß durch die unterschiedliche Dotierung der beiden Teilerwiderstände ein temperaturabhängiges Deckelektrodenpotential erhalten wird. Die Dotierung der beiden Teilerwiderstände erfolgt dabei in der Weise, daß die sich dadurch ergebenden unterschiedlichen Temperaturkoeffizienten eine temperaturabhängige Potentialänderung bewirken, die der temperaturabhängigen Änderung der Durchbruchsspannung entgegenwirkt. In Abhängigkeit vom jeweiligen Aufbau der Halbleiteranordnung und im Hinblick auf die jeweils gestellten Anforderungen kann die unterschiedliche Dotierung so erfolgen, daß eine weitgehende Temperaturstabilisierung der Durchbruchsspannung erzielt wird. Um nachträglich einen Abgleich des Spannungsteilers zu ermöglichen, können in den Spannungsteiler kurzschließbare Zenerdioden eingebaut sein.

Ein Verfahren zur Herstellung der erfindungsgemäßen Halbleiteranordnung ist dadurch gegeben, daß beide Widerstände des Spannungsteilers zunächst aus einem schwach dotierten Halbleitermaterial gebildet werden, daß einer der Widerstände dann mit einer Lackschicht abgedeckt wird, und daß danach durch Ionenimplantation der andere Widerstand mit einer höheren Dotierung versehen wird. Anstelle der für die Maskierung bzw. für die Abdeckung des einen Widerstandes vorgesehenen Lackschicht könnte auch eine Oxidschicht verwendet werden. Versuche haben jedoch gezeigt, daß der abzudeckende Widerstand in besonders vorteilhafter Weise mittels einer Lackschicht abgedeckt werden kann.

### Zeichnung

Die Erfindung wird nachfolgend anhand der Zeichnungen näher erläutert. Es zeigen:

Figur 1 einen Teilschnitt eines pn-Überganges mit einem Spannungsteiler zur Einstellung der Durchbruchsspannung am pn-Übergang,

Figur 2 die Durchbruchsspannung am Pn-Übergang in Abhängigkeit vom Teilerverhältnis des Spannungsteilers und

Figur 3 eine Draufsicht auf eine erfindungsgemäße, als Darlington-Transistorschaltung ausgebildete Halbleiteranordnung mit integriertem Spannungsteiler.

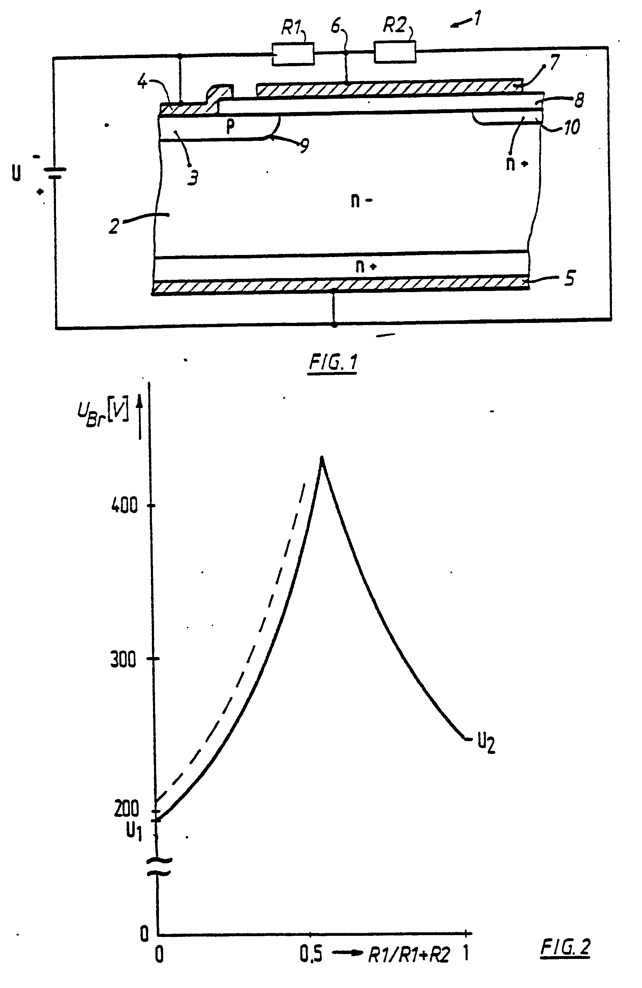

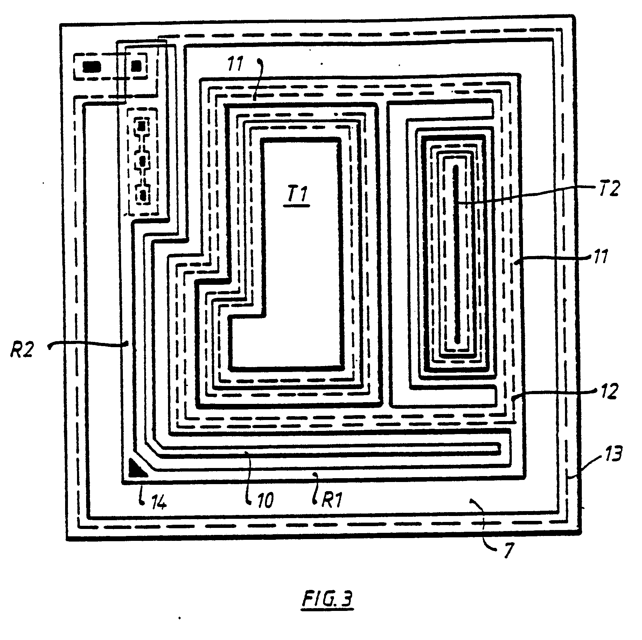

Der in Figur 1 dargestellte Schnitt im Bereich eines pn-Überganges ist mit einem Spannungsteiler 1 verbunden, der hier der Übersichtlichkeit wegen als externer Spannungsteiler dargestellt ist. Tatsächlich wird dieser Spannungsteiler 1 jedoch durch zwei Widerstandsstreifen gebildet, wie dies in Figur 3 dargestellt ist.

Die dargestellte Halbleiteranordnung besteht im wesentlichen aus einem $n^{-}$-leitenden Substrat 2, in das eine p-leitende Zone 3 eindiffundiert ist. Oberhalb der p-Zone 3 befindet sich eine Metallelektrode 4, die mit dem Minuspol einer Spannungsquelle U und dem ersten Teilerwiderstand R1 des Spannungsteilers 1 verbunden ist. Der zweite Widerstand R2 des Spannungsteilers 1 und der Pluspol der Spannungsquelle U sind mit einer an der Unterseite des Substrates 2 aufgebrachten Metallisierung 5 verbunden. Die am Abgriff 6 des Spannungsteilers 1 auftretende Teilerspannung liegt an einer Deckelektrode 7 an, die über einer Oxidschicht 8 so aufgebracht ist, daß sie den pn-Übergang und die im Sperrbetrieb auftretenden Raumladungsgebiete überdeckt. Während die Raumladung wegen der gegenüber dem $n^{-}$-Gebiet (Substrat 2) höheren Dotierung nicht weit in das p-Gebiet 3 reicht, wird sie in dem $n^{-}$-Gebiet durch eine eindiffundierte $n+$-Zone 10 begrenzt. Durch die über der als Isolator dienenden Oxidschicht 8 angebrachten Deckelektrode 7 wird der Pn-Übergang 9 so geschützt, daß das Sperrverhalten durch äußere Einflüsse (z. B. Stoffe mit polaren Gruppen, Alkaliionen, Metallflitter usw.) nicht in unerwünschter Weise beeinflußt werden kann.

Der dargestellte Schnitt zeigt einen Pn-Übergang, der Teil einer Diode oder einer Transistorschaltung sein kann. Die Deckelektrode 7, die als Metallelektrode ausgebildet ist, überlappt ein $n+$-Gebiet 10, welches gleichzeitig mit dem oder den Emittern einer Transistorschaltung eindiffundiert wird. Die erreichbare Durchbruchsspannung $U_{Br}$ an dem dargestellten pn-Übergang 9 hängt außer von der Grunddotierung des Siliziums (Substrat 2) wesentlich von der Dicke der aus Siliziumdioxid bestehenden Oxidschicht 8 und dem Potential der Deckelektrode 7 ab.

Figur 2 zeigt die Abhängigkeit der Durchbruchsspannung $U_{Br}$ als Funktion des Teilerverhältnisses $R1/R1 + R2$ des Spannungsteilers 1. Dabei ist U1 die Durchbruchsspannung am pn-Übergang 9, die man erhält, wenn die Deckelektrode 7 ohne Zwischenschaltung des Widerstands R1 direkt an die p-Zone 3 angeschlossen ist.

Sie ist im vorliegenden Beispiel deutlich kleiner als diejenige Durchbruchsspannung, die ohne Deckelektrode 7 erzielbar ist. Die Durchbruchsspannung U2 erhält man, wenn der Widerstand R2 kurzgeschlossen wird.

Mit unterbrochener Linie ist der ansteigende Ast der Durchbruchsspannung eingetragen, wie er sich bei einer höheren Temperatur ergibt. Werden nun die beiden Widerstände R1 und R2 mit unterschiedlichen Temperaturkoeffizienten versehen, so läßt sich die Temperaturabhängigkeit der Durchbruchsspannung kompensieren. Durch unterschiedlich hohe Dotierung kann der Temperaturkoeffizient des ersten Widerstandes R1 beispielsweise $6 \cdot 10^{-3}$/K und der des zweiten Widerstandes R2 $8 \cdot 10^{-3}$/K betragen. Für den linken Zweig der in Figur 2 dargestellten Kurve gilt dann:

$$U_{Br} = U1 (R1/R2 + 1)$$

es sei U1 (25°C) = 200 V; R1/R2 (25°C) = 1
und U1 (125°C) = 212 V,
damit ist $U_{Br}$ (25°C) = 400 V

bei einer Temperatur von 125°C gilt dann:

R2 (125°C) = 1,8 · R2 (25°C)
R1 (125°C) = 1,6 · R1 (25°C)

somit ist $U_{Br}$ (125°C) $\approx$ 400 V.

Durch geeignete Dotierung kann also eine gewünschte Temperaturstabilisierung der Durchbruchsspannung erhalten werden.

Das in Figur 3 dargestellte Ausführungsbeispiel zeigt, wie der Spannungsteiler 1 monolithisch integriert werden kann. Der Spannungsteiler 1 besteht aus zwei eindiffundierten langgestreckten p-leitenden Zonen, die die Widerstände R1 und R2 bilden. Dem Spannungsteiler 1 ist ein Sperrstreifen 10 benachbart, der $n^+$-dotiert ist. Dieser Sperrstreifen 10 liegt zwischen dem Spannungsteiler 1 und einer p-Zone 11, die das Basisgebiet zweier Transistoren T1 und T2 bildet. Der Sperrstreifen 10 wirkt einer elektrischen Verbindung entgegen, die bei Anlegen der Sperrspannung über die Raumladung zwischen dem Teiler 1 und dem pn-Übergang 9 auftreten könnte.

Die Begrenzung der Deckelektrode 7 ist durch unterbrochene Linien 12 und 13 eingezeichnet. Ein Kontaktfenster 14, welches den Abgriff 6 des Spannungsteilers 1 bildet, ist mit der Deckelektrode 7 elektrisch verbunden.

Die beiden Widerstände R1 und R2 können zunächst aus einem schwach dotierten Halbleitermaterial gebildet werden, wobei der Widerstand R1 zusätzlich mittels Ionenimplantation mit einer höheren Dotierung versehen werden kann. Der Widerstand R2 kann vor Anwendung der Ionenimplantation durch eine Lackschicht überdeckt werden.

Durch die unterschiedlich hohe Dotierung erhält man für die beiden Widerstände R1, R2 unterschiedliche Temperaturkoeffizienten, die beispielsweise die oben im Zusammenhang mit Figur 2 angegebenen Werte aufweisen können.

Der weitere Aufbau der in Figur 3 dargestellten Halbleiteranordnung ist ansich bekannt und wird in der genannten DE-A-32 27 536 ausführlich beschrieben.

## Patentansprüche

1. Monolithisch integrierte planare Halbleiteranordnung mit wenigstens einem pn-Übergang, der durch das einen bestimmten Leitfähigkeitstyp aufweisende Substrat und eine in das Substrat eindiffundierte Zone entgegengesetzten Leitfähigkeitstyps gebildet ist, mit einer über einer Passivierungsschicht angeordneten Deckelektrode, die die im Sperrbetrieb auftretenden Raumladungsgebiete überdeckt, und mit einem aus einem ersten und einem zweiten integrierten Widerstand bestehenden Spannungsteiler, der dem pn-Übergang parallel geschaltet und dessen Abgriff mit der Deckelektrode verbunden ist, dadurch gekennzeichnet, daß die beiden Widerstände (R1, R2) eine derart unterschiedlich hohe Dotierung und damit bezüglich ihrer Widerstandswerte unterschiedliche Temperaturkoeffizienten aufweisen, daß die an der Deckelektrode (7) anliegende temperaturabhängige Spannung die am pn-Übergang (9) auftretende Durchbruchsspannung ($U_{Br}$) weitgehend temperaturstabilisiert.

2. Halbleiteranordnung nach Anspruch 1, dadurch gekennzeichnet, daß mit dem Spannungsteiler (1) zusätzliche kurzschließbare Zenerdioden zum Abgleich der Durchbruchsspannung $U_{Br}$ intergriert sind.

3. Verfahren zur Herstellung einer Halbleiteranordnung gemäß Patentanspruch 1, dadurch gekennzeichnet, daß beide Widerstände (R1, R2) des Spannungsteilers (1) zunächst aus einem schwach dotierten

**0 179 099**

Halbleitermaterial gebildet werden, daß einer der Widerstände (R2) dann mit einer Lackschicht abgedeckt wird, und daß danach durch Ionenimplantation der andere Widerstand (R1) mit einer höheren Dotierung versehen wird.

**Claims**

1. Monolithically integrated planar semiconductor arrangement having at least one pn junction, which is formed by a substrate exhibiting a particular type of conductivity and a zone of opposite type of conductivity diffused into the substrate, with a cover electrode arranged above a passivation layer, which electrode covers the space charge regions occurring in reverse operation, and with a voltage divider consisting of a first and a second integrated resistance which is connected in parallel with the pn junction and the tap of which is connected to the cover electrode, characterized in that the two resistances (R1, R2) exhibit doping of such different levels, and thus temperature coefficients which are different with respect to their resistance values, that the temperature-dependant voltage present across the cover electrode (7) substantially temperature-stabilizes the breakdown voltage ($U_{Br}$) occurring across the pn junction (9).

2. Semiconductor arrangement according to claim 1, characterized in that Zener diodes, which can be shortcircuited, are additionally integrated with the voltage divider (1) for calibrating the breakdown voltage $U_{Br}$.

3. Method for producing a semiconductor arrangement according to claim 1, characterized in that the two resistances (R1, R2) of the voltage divider (1) are initially formed from a weakly doped semiconductor material, in that one of the resistances (R2) is then covered with a layer of resist and in that thereafter the other resistance (R1 ) is provided whith a higher level of doping by means of ion implantation.

**Revendications**

1. Dispositif semi-conducteur planaire monolithique intégré, avec au moins une jonction pn, qui est constituée par le substrat, d'un type de conductibilité déterminé, et une zone du type de conductibilité opposé diffusée dans le substrat, avec une électrode de recouvrement disposée par dessus une couche de passivation et qui recouvre les régions de charge d'espace apparaissant en fonctionnement bloqué, et avec un diviseur de tension constitué d'une première et d'une seconde résistance intégrée, qui est branché en parallèle sur la jonction pn et dont la prise est reliée à l'électrode de recouvrement, dispositif caractérisé en ce que les deux résistances (R1, R2) comportent un dopage élevé différent et donc des coefficients de température différents en ce qui concerne leurs valeurs de résistance, et en ce que la tension dépendant de la température, appliquée à l'électrode de recouvrement (7), stabilise en température, dans une large mesure, la tension de claquage ($U_{Br}$) apparaissant sur la jonction pn (9).

2. Dispositif semi-conducteur selon la revendication 1, caractérisé en ce que des diodes de Zener supplémentaires, susceptibles d'être court-circuitées, sont intégrées avec le diviseur de tension (1) pour compenser la tension de claquage ($U_{Br}$).

3. Procédé pour réaliser un dispositif semiconducteur selon la revendication 1, procédé caractérisé en ce que les deux résistances (R1, R2) du diviseur de tension (1) sont tout d'abord réalisées à partir d'un matériau semi-conducteur faiblement dopé, que l'une (R2) de ces résistances est ensuite recouverte d'une couche de laque et qu'ensuite, par implantation d'ions, l'autre résistance (R1) est pourvue d'un dopage plus élevé.

4

0 179 099

FIG. 1

FIG. 2

*FIG. 3*